# EUROPÄISCHE PATENTSCHRIFT

(11) **EP 2 228 818 B1**
(45) Veröffentlichungstag und Bekanntmachung des Hinweises auf die Patenterteilung: **15.08.2018**
(21) Anmeldenummer: 10155304.8
(22) Anmeldetag: 03.03.2010
(51) Int. Cl.: H01J 37/32

(54) **Verfahren zur Überwachung von Plasma-Entladungen**
Method for monitoring plasma discharges
Procédé de surveillance des décharges de plasma

(30) Priorität: 10.03.2009 DE 102009011960
(43) Veröffentlichungstag der Anmeldung: 15.09.2010
(73) Patentinhaber: Schott AG, 55122 Mainz (DE)
(72) Erfinder: Bauch, Hartmut, 55270, Ober-Olm (DE); Bicker, Matthias, 55126, Mainz/Finthen (DE)
(74) Vertreter: 2K Patentanwälte Blasberg Kewitz & Reichel

(56) Entgegenhaltungen:
- EP-A2- 0 347 717
- WO-A1-2008/100296
- US-A1- 2005 109 739

## Beschreibung

Die Erfindung betrifft ein Verfahren und eine Vorrichtung zur Überwachung von Plasma-Entladungen nach dem Oberbegriff des Anspruchs 1 bzw. des nebengeordneten Anspruchs. Insbesondere betrifft die Erfindung ein Verfahren sowie eine Vorrichtung zur Überwachung von Plasma-Entladungen (auch Plasma-Zündungen genannt) während eines Oberflächen-Behandlungsverfahrens, bei dem Elektroden in einem gasförmigen Medium zur Erzeugung von Plasma mit einer Wechselspannung beaufschlagt werden. Darunter fallen beispielsweise Verfahren, bei denen Plasma zur Beschichtung und Modifikation von Oberflächen diverser Produkte, wie etwa pharmazeutischer Packmittel aus Glas und/oder Kunststoff, erzeugt wird. Bei solchen Verfahren kommt oft auch die sog. dielektrische Barriere-Entladung (Englisch: "Dieletric Barrier Discharge"), kurz auch als DBD bezeichnet, zum Einsatz. Hierbei werden durch Einwirkung Wechselspannungen von z.B. 10-100 kHz und unter dielektrischer Abschirmung einer Elektrode kurzzeitige, nur wenige Mikrosekunden dauernde Plasma-Entladungen erzeugt.
Die Stabilität der Plasma-Entladungen und somit auch die Qualität solcher Oberflächen-Behandlungsverfahren hängt von mehreren Bedingungen, wie z.B. Druck, Gasfluss, GasZusammensetzung und Oberflächen-Beschaffenheit ab. Deshalb müssen bei der industriellen Anwendung solcher Oberflächen-Behandlungsverfahren geeignete Messmethoden und -mittel zur Überwachung der Plasma-Entladungen eingesetzt werden.

Aus der WO 2008/100296 A1 sind ein Verfahren und eine Vorrichtung zur Überwachung von Plasma-Entladungen bekannt, wobei zur Erzeugung von Plasma Elektroden in einem gasförmigen Medium mit einer Wechselspannung beaufschlagt und wobei ein Messsignal erfasst wird, das eine Messgröße für die durch die Wechselspannung in dem Medium erzeugte elektrische Energie darstellt. Dann werden Signalanteile des Messsignales separiert, die oberhalb einer vorgebbaren Frequenz liegen und die die separierten Signalanteile des Messsignales werden durch Vergleich mit mindestens einer vorgebaren Referenz ausgewertet. Hierzu wird eine Spektralanalyse in Form einer FFT-Analyse durchgeführt und die Spektralanteile werden mit einem Referenzspektrum verglichen.

Bekannt sind auch Verfahren und Vorrichtungen zur Überwachung von Plasma-Entladungen mittels optischer Überwachung der Lichtemission, welche bei auftretenden Plasma-Entladungen durch die damit einhergehende Erzeugung von Photonen erfasst werden können. Beispielsweise wird anhand der Intensität der Lichtemission und insbesondere durch spektraloptische Diskriminierung derselben der Ablauf des Behandlungsprozesses überwacht und gesteuert. Diese Vorgehensweise, die auch als "Optical Emission Spectroscopy", kurz OES, bezeichnet wird ist beispielsweise in folgenden Offenlegungsschriften offenbart: US-A-2003223055, EP-A-1630848 sowie EP-A-0821079. Das OES-Verfahren hat jedoch den Nachteil, dass ein hoher Realisierungsaufwand durch Einsatz von optoelektronischen Komponenten, Filtern, Spektrometern und dergleichen erforderlich ist.

Es sind auch andere Verfahren zur Überwachung von Plasma-Entladungen bekannt, die eingesetzt werden, wenn das Plasma durch Einwirkung von RF-Energie erzeugt wird. Hierbei bewirkt eine hochfrequente Wechselspannung von z.B. 13 MHz eine Plasma-Erzeugung im stationären Zustand. Zur Überwachung des Vorgangs wird mittels einer sog. Match-Box die Plasma-Impedanz gemessen. Solche Verfahren sind beispielsweise in folgenden Patent- bzw. Offenlegungsschriften beschrieben: US-B-6291999 sowie US-A-5576629. Aus der Patentschrift US-B-7169625B ist sogar ein Verfahren zur Überwachung von Plasma-Entladungen bekannt, bei dem eine Kombination von Messungen der optischen Lichtemission (OES) und der RF-Parameter vorgeschlagen wird, wobei jedoch nicht näher beschrieben wird, welche RF-Parameter wie gemessen werden sollen. Auch diese bekannten Verfahren erfordern einen recht hohen Aufwand an Messinstrumenten und -geräten.

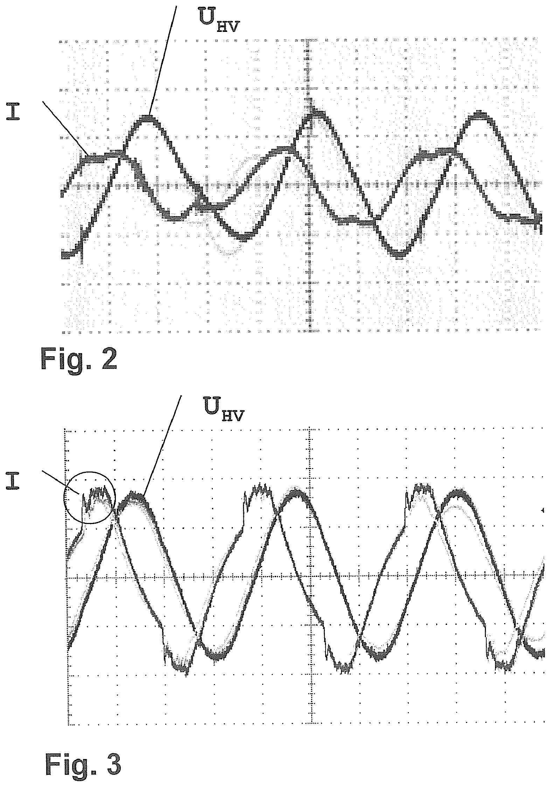

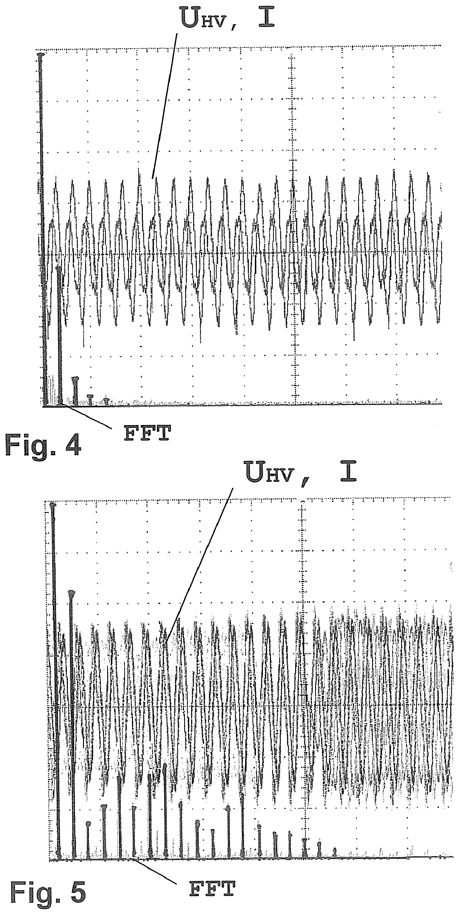

In der US 2005/ 109739 A1 werden ein Verfahren und System zur Erzeugung von Plasma für Desinfektion und Sterilisation mittels biozidem Gas (s. dort [0001]-[0002]) beschrieben. Dazu wird eine Wechselspannung von einem Hochspannung-Generator 20 erzeugt und an die Elektroden 26 und 28 in einer Plasma-Kammer angelegt (s. dort Fig. 2), wobei es dort insbesondere um die Steuerung bzw. Regelung der Amplitude der Generatorspannung gehet (siehe [0047]) und weniger um die Überwachung von Plasma-Entladungen an sich. Zwar wird dort auch eine Messgröße erfasst (s. dort Fig. 2 und [0043]); allerdings handelt es sich dabei um einen Strom, der Maßstab für die mittlere Häufigkeit von auftretenden Entladungen ist und nicht (direkt) die erzeugte elektrische Energie darstellt. Vielmehr wird in D1 (s. dort Fig. 3 sowie Fig. 5C und [0048]) darauf abgestellt, das gefilterte Meßsignal 76 über einen Schwellwert-Vergleicher ("comparator 52" und "threshold potentiometer 54") in ein logisches Signal 78 umzuwandeln, welches die Häufigkeit der Entladungen anzeigt. Des Weiteren wird dort offenbart, die Generatorspannung zu steuern bzw. zu regeln, nicht aber die Plasma-Entladung im eigentlichen Sinne zu überwachen.

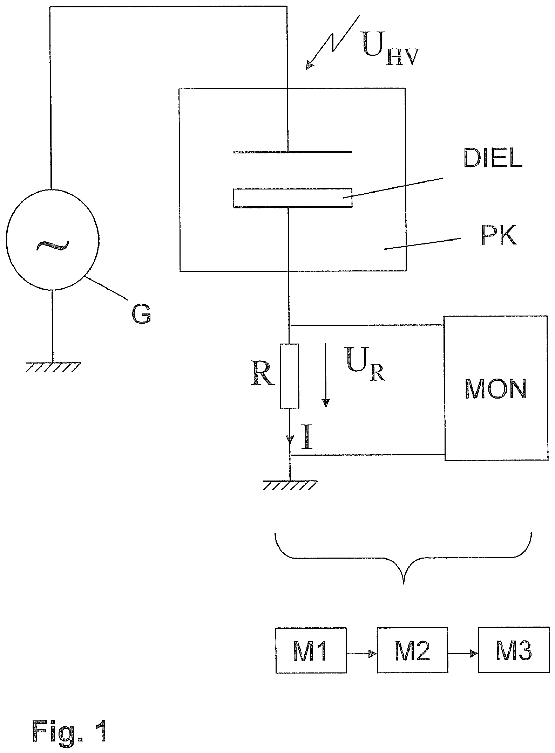

Aus der EP 0 347 717 A2 ist ein Verfahren zur Überwachung von Plasma-Entladungen während eines Oberflächen-Behandlungsverfahrens, bei dem Elektroden in einem gasförmigen Medium zur Erzeugung von Plasma mit einer Wechselspannung beaufschlagt werden, um einen hochfrequenten Wechselstrom mit einer Anregungs-Frequenz von z.B. 13,56 Mhz zu erzeugen, so dass sich ein Plasma ausbilden kann. Um zu erkennen, ob dies der Fall ist, wird eine Messschaltung (s. Komponenten 9 und 11-14 in Fig. 1) offenbart, welche folgende Schritte ausführt: Mittels einer Messspule 9 wird ein Messsignal erfasst, das proportional zu dem Elektroden-Strom J ist und somit eine Messgröße für die durch die Wechselspannung in dem Medium erzeugte elektrische Energie darstellt. Dann werden mittels eines Hochpass-Filters 11 die Signalanteile des Messsignales separiert, welche oberhalb einer vorgebbaren Frequenz (dort 20 Mhz) liegen, die größer als die Grundfrequenz ist. Am Ausgang des Hochpass-Filters 11 steht nur dann ein Messsignal an, wenn ein Plasma vorliegt, denn nur dann bilden sich zusätzlich zur Grundfrequenz noch Oberwellen aus. Das Messsignal am Ausgang des Hochpass-Filters 11 wird gleichgerichtet (Gleichrichter 12) und geglättet (Tiefpass 13). Das daraus resultierende Amplituden-Signal wird auf einer Anzeigevorrichtung 14 angezeigt und ist ein Maß für die Oberwellen und damit ein Maß für die Ausbildung des Plasmas. Durch diese relativ einfache und kostengünstige Schaltung kann das Vorliegen von Plasma an sich überwacht werden. Wünschenswert wäre jedoch eine Überwachung bzw. Auswertung, die auch die Qualität des Plasmas wiedergibt.

Als weitere Druckschriften aus dem Stand der Technik sind zu nennen: US 2006/0116106 A1 und US 2005/0183821 A1. und WO 2008/100296 A1.

Demnach ist es Aufgabe der vorliegenden Erfindung, ein Verfahren und eine Vorrichtung zum Überwachen von Plasma-Entladungen vorzuschlagen, die möglichst einfach und kostengünstig zu realisieren sind und auch eine Überwachung der Qualität des Plasmas ermöglichen. Insbesondere soll ein Verfahren und eine Vorrichtung zur Überwachung von Plasma-Entladungen vorgeschlagen werden, die besonderes vorteilhaft im Zusammenhang mit dielektrischer Barriere-Entladung (DBD) eingesetzt werden können.

Gelöst wird die Aufgabe durch ein Verfahren mit den Merkmalen des Anspruchs 1 sowie durch eine Vorrichtung mit den Merkmalen des nebengeordneten Anspruchs.

Demnach wird vorgeschlagen, zuerst ein Messsignal zu erfassen, das eine Messgröße für die durch die Wechselspannung in dem Medium erzeugten elektrischen Energie darstellt, dann solche Signalanteile des Messsignals zu separieren bzw. getrennt zu detektieren, welche oberhalb einer vorgebbaren Frequenz liegen, und schließlich die separierten Signalanteile des Messsignals durch Vergleich mit mindestens einer vorgebbaren Referenz bzw. Mustervorgabe auszuwerten. Dabei erfolgt die Erzeugung des Plasmas mittels einer dielektrischen Barriere-Entladung.

Bevorzugt wird als Messgröße ein das Medium durchdringender, dielektrischer Verschiebestrom gemessen.

In einer bevorzugten Ausführungsform erfolgt das Separieren und Auswerten der Signalanteile des Messsignales mittels einer Spektralanalyse, die eine Fast-Fourier-Analyse (FFT) umfasst, wobei die den Signalanteilen entsprechenden Spektralanteile mit einem als Referenz dienenden Referenzspektrum verglichen werden. Die erfindungsgemäße Vorrichtung weist dazu Detektormittel, Trennmittel sowie Auswertungsmittel auf.

Durch die Erfindung kann unter Anwendung von Separation und Auswertung des Messsignals, vorzugsweise innerhalb einer entsprechenden Signalverarbeitung, kann dann ein für die Plasma-Eigenschaften relevantes Nutzsignal extrahiert werden. Vorzugsweise wird bei Einsatz von DBD als Messgröße ein das Medium durchdringender Strom, insbesondere ein dielektrischer Verschiebestrom, gemessen. Dies kann beispielsweise anhand eines Messwiderstandes erfolgen, der einen Spannungsabfall erzeugt und ein zu dem Strom proportionales Spannungssignal abgibt. Von dem gemessenen Signal werden die Signalanteile mit höheren Frequenzen separiert, wobei hierzu eine Spektralanalyse, in Form einer Fast-Fourier Analyse, eingesetzt wird. Die betrachteten Signalanteile liegen vorzugsweise oberhalb einer anregenden Frequenz, wobei die anregende Frequenz z.B. 10-100 kHz betragen kann.

Nicht nur das Separieren der Signalanteile, sondern auch das Auswerten der separierten Signalanteile werden mittels einer Spektralanalyse, einschließlich einer Fast-Fourier Analyse, durchgeführt, wobei die den Signalanteilen entsprechenden Spektralanteile mit einem als Referenz dienenden Referenzspektrum verglichen werden. Das Referenzspektrum wird vor dem Auftreten einer Plasma-Entladung bzw. -Zündung aufgenommen. Alternativ dazu kann das Auswerten der aufgetretenen Signalanteile auch mittels einer Differenzenbildung durchgeführt werden, bei der die Signalanteile des Messsignals mit einem Referenzsignal verglichen werden. Auch das Referenzsignal wurde vor dem Auftreten einer Plasma-Zündung aufgenommen.

Zur Auswertung der hier interessierenden Hochfrequenz-Signalanteile kann ein Schwellwert herangezogen werden, der beispielsweise einem Signalwert (Betrag, Phase) im Spektralbereich (Betrag, Phase) oder im Zeitbereich (Signalverlauf) entspricht.

Diese und weitere vorteilhafte Ausgestaltungen ergeben sich auch aus den Unteransprüchen.

Nachfolgend wird die Erfindung eingehender anhand eines Ausführungsbeispieles und unter Zuhilfenahme der beiliegenden Figuren, näher beschrieben, wobei:
- Figur 1: das elektrische Ersatzschaltbild für eine Anordnung zur Erzeugung eines Plasmas zur Beschichtung einer pharmazeutischen Verpackung, wie z.B. einer Spritze, zeigt;
- Figur 2: den Messsignal-Verlauf vor dem Auftreten von Plasma-Entladungen zeigt;
- Figur 3: den Messsignal-Verlauf bei auftretenden Plasma-Entladungen zeigt;
- Figur 4: passend zur Figur 2 aber nun über ein längeres Zeitintervall den Messsignal-Verlauf ohne auftretende Plasma-Entladungen und das daraus gewonnene Messsignal-Spektrum zeigt;
- Figur 5: passend zur Fig. 3 aber nun über ein längeres Zeitintervall den Messsignal-Verlauf bei auftretenden Plasma-Entladungen und das daraus gewonnene Messsignal-Spektrum zeigt; und
- Figur 6: ein Ablaufdiagramm für das erfindungsgemäße Verfahren zeigt.

Die Fig. 1 zeigt in Form eines Blockschaltbildes das elektrische Ersatzschaltbild für eine Anordnung zur Erzeugung eines Plasmas durch dielektrische behinderte Barriere-Entladung (DBD). Im Ersatzschaltbild stellt die Anordnung einen mit einem Dielektrikum DIEL versehenen Kondensator dar, in dem beim Anlegen einer elektrischen Wechselspannung U_{HV} einen dielektrischen Verschiebestrom I erzeugt wird. Hier wird von einem Generator G beispielsweise eine sinusförmige Wechselspannung U_{HV} mit einer Amplitude von 2 kV und einer Frequenz von 15 kHz erzeugt und an die Elektroden innerhalb einer Plasma-Kammer PK angelegt, wobei eine der Elektroden mit einem Dielektrikum (z.B. Glasplatte) abgeschirmt ist, um einen ohmschen Kurzschluss zu vermeiden. Somit wird ausschließlich ein dielektrischer Verschiebestrom I erzeugt, der an einer der Zuleitungen über einen Messwiderstand R als entsprechender Spannungsabfall U_{R} abgegriffen werden kann und der Überwachungs-Vorrichtung MON zugeführt werden kann.

So lange keine Plasma-Entladung auftritt, fließt ein dielektrischer Verschiebestrom I, der idealerweise rein sinusförmig ist und der erzeugenden Spannung U_{HV} phasenversetzt folgt (siehe auch Fig. 2). Dieser Strom I wird als Messgröße durch die erfindungsgemäße Vorrichtung MON erfasst, um den in dem Medium bzw. der Plasma-Kammer PK auftretende Plasma-Entladungen zu überwachen. Bei den in Fig. 2 und 3 dargestellten Amplitudenverläufe über der Zeitachse wird von folgendem Rastermaße (Kästchen) ausgegangen: Auf der Zeitachse entspricht ein Kästchen 2 Mikrosekunden; auf der Amplitudenachse entspricht ein Kästchen 1000 Volt bzw. 10 Milli-Ampere.

Wie auch diese Figuren verdeutlichen, liegt der Erfindung liegt die Erkenntnis zu Grunde, dass bereits durch Messung des Stromes I oder einer vergleichbaren Messgröße der Energiezustand in der Plasma-Kammer PK und insbesondere das Auftreten von Plasma-Entladungen bzw. Plasma-Zündungen zuverlässig erkannt werden können. Daher sind keine optischen Messmittel oder dergleichen erforderlich. Zudem können durch Auswertung der Messgröße I auch Erkenntnisse über die Quantität und Qualität der Plasma-Entladungen gewonnen werden.

Denn bei Auftreten von Plasma-Entladungen erhöht sich sprunghaft der elektrische Strom I für eine begrenzte Zeitdauer, wobei ein charakteristischer Signalverlauf zu erkennen ist (siehe in Fig. 3 den eingekreisten Bereich). Dies ergibt sich daraus, dass im Bereich der maximalen Amplituden der Wechselspannung U_{HV} oberhalb einer systembedingten Feldstärke sich das wirksame Dielektrikum DIEL ändert und die Impedanz geringer wird, so dass der Strom I sprunghaft ansteigt und eine Plasma-Zündung entsteht. Dann reduziert sich im zeitlichen Verlauf der Wechselspannung der Amplitudenwert U_{HV} wieder und das Plasma erlischt; der Strom I entspricht dann wieder dem rein sinusförmig verlaufendem dielektrischen Verschiebestrom. Beim Auftreten des Plasmas entstehen somit im oberen Bereich der positiven sowie im unteren Bereich der negativen Halbwelle periodisch auftretende Stromimpulse (siehe Fig. 3), die typische Ausprägungen haben und somit jeweils eine Plasma-Zündung anzeigen.

Mit anderen Worten schlägt die Erfindung eine zeitaufgelöste Messung der elektrischen Energie vor, hier in Form einer Strommessung bei aufgeprägter Spannung. Durch die Anwendung von einzelnen oder kombinierten Signalverarbeitungs-Funktionen, wie z.B. Diskriminatoren, Hoch- und Tiefpassfilter, Fourier-Transformationen, Spektrumsanalyse, kann aus den gemessenen Signalen somit ein Nutzsignal extrahiert werden, das die Plasma-Eigenschaften widerspiegelt. Mittels geeigneter nachgeschalteter Auswertelogik bzw. intelligenter Rechnertechnik lässt sich dies auch vorteilhaft durch hierfür angepasste Software erzielen. Das erzeugte Nutzsignal lässt sich nicht nur zu einer Prozessüberwachung, sondern auch zur Prozessregelung, einsetzen.

Die Erfindung schlägt also vor, das Auftreten eines elektrischen Pulssignals zu überwachen, um dann daraus das Auftreten einer Gasentladung bzw. Gaszündung zu erkennen, wobei die Überwachungs-Vorrichtung MON (s. Fig. 1) hierzu über entsprechende Mittel bzw. Einheiten verfügt, insbesondere über Detektormittel M1, die das Messignal erfassen, über Trennmittel M2, die daraus die höherfrequenten Signalanteile separieren, und über Auswertemittel M3, die die Signalanteile mittels Vergleich auswerten.

Zur weiteren Verdeutlichung der Erfindung zeigt die Fig. 4 den zeitlichen Verlauf der elektrischen Wechselspannung U_{HV} über einen größeren Zeitraum und den sich ergebenden dielektrischen Verschiebestrom I. Im unteren Bereich des Bildes ist die spektrale Darstellung der FourierTransformierten FFT des Stromsignals I dargestellt. Die Fig. 4 bezieht sich auf den Zeitraum vor einer Plasma-Zündung. Demnach sind insbesondere in den höheren Frequenzbereichen ab etwa 500kHz keine nennenswerten Spektralanteile vorhanden.

Die Figur 5 bezieht sich auf die Situation, bei der eine Plasma-Entladung bzw. Plasma-Zündung auftritt. Auch hier sind die Wechselspannung U_{HV}, der Strom I sowie die Fourier-Transformierte FFT davon eingezeichnet. Deutlich zu erkennen ist, dass nun auch in den höheren Frequenzbereichen nennenswerte Spektralanteile vorhanden sind.

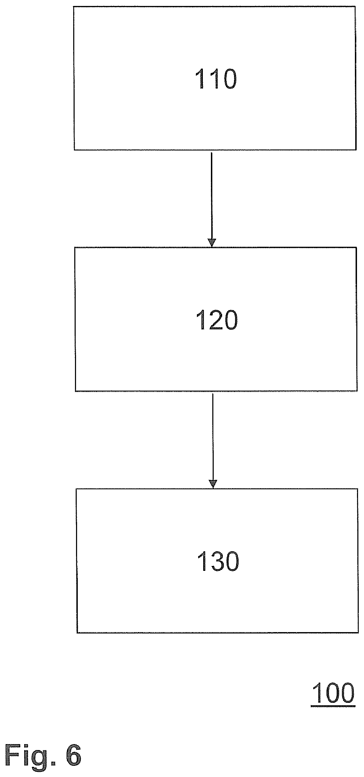

Die Fig. 6 zeigt schließlich den Ablauf des erfindungsgemäßen Verfahrens 100 mit den Schritten 110 bis 130. Das Verfahren 100 umfasst insbesondere folgende Schritte (siehe dazu auch die zuvor beschriebenen Fig. 1 bis 5):
In einem ersten Schritt 110 wird ein Messsignal erfasst, das eine Messgröße, hier also den Strom I, für die durch die Wechselspannung U_{HV} in dem Medium erzeugte elektrische Energie darstellt. In einem nächsten Schritt 120 werden dann diejenigen Signalanteile des Messsignals getrennt, die oberhalb einer anregenden Frequenz liegen. Hier die anregende Frequenz etwa 100kHz, die getrennten Signalanteile liegen oberhalb davon im Bereich von z.B. 500kHz. In einem weiteren Schritt 130 werden dann die separierten Signalanteile des Messsignals I durch Vergleich mit mindestens einer vorgebbaren Referenz ausgewertet. Die Erfindung schlägt also vor, das Auftreten eines elektrischen Pulssignals zu überwachen, um dann daraus das Auftreten einer Gasentladung bzw. Gaszündung zu erkennen.

Das Verfahren und die danach arbeitende Vorrichtung MON (siehe Fig. 1) sind insbesondere für die Überwachung von dielektrisch behinderten Barriere-Entladungen geeignet. Hierbei wird atmosphärisches Plasma innerhalb eines Hohlkörpers von Glas, Kunststoff o.ä. erzeugt. Als gasförmiges Medium wird Helium oder Argon oder auch eine Mischung beider Gase eingesetzt. Ein Hochspannungsgenerator G mit einer Ausgangsleistung von z.B. 10 kW (SS) steht zur Verfügung. Die Wechselspannung U_{HV} kann eine Frequenz von beispielsweise 10 bis 100 kHz aufweisen, die der anregenden Frequenz entspricht. Die Wechselspannung U_{HV} wird an eine in dem Hohlkörper sich befindende Spitze bzw. Elektrode geführt. Außen um den Hohlkörper herum befindet sich als Gegenelektrode eine metallische Hülse. Das gasförmige Medium wird durch spezielle Bohrungen in den Hohlkörper geleitet. Somit stellt die Anordnung den in Fig. 1 dargestellten koaxialförmigen Kondensator dar. Beim Anlegen der Wechselspannung U_{HV} fließt dann ein um 90° phasenverschobener, dielektrischer Verschiebestrom I. Sobald das Plasma entsteht, bildet dieses wechselstrommäßig einen Teil-Kurzuschluß über dem Gasraum zwischen Mittelelektrode und Glaswandung.

Die Fig. 3 und 4 zeigen Verläufe von Spannungen, Strom sowie die Spektralanalyse für den hier geschilderten Anwendungsfall. Beispielsweise wird mittels einer schnellen Fourier-Transformation das Stromsignal einer Spektralanalyse unterzogen. Im Falle einer Plasma-Zündung zeigt sich so im Spektrum des Messsignals ein hoher Anteil an hochfrequenten Spektralanteilen. Die anhand des Messsignals und der Spektralanalyse ausgewerteten Spektralfrequenzen und/oder deren Amplituden lassen sich dann leicht empirisch mit den vorherrschenden Plasmabedingungen, wie z.B. Druck, Gasflüsse und -zusammensetzung, Oberflächenbeschaffenheit und dergleichen, in Koordination bringen. Hierdurch ist eine Überwachung von Plasma-Entladungen unter Einsatz von wenigen Messmitteln möglich. Auch lässt sich die Gesamtprozessregelung hiermit steuern.

### Bezugszeichenliste

- G: Hochspannungs-Generator
- U_{HV}: Wechselspannung (20-100kHz)
- DIEL: Dielektrikum
- PK: Plasmakammer

- MON: Überwachungs-Vorrichtung
- M1: Detektormittel (einschl. Widerstand R)
- M2: Trennmittel (hier Filter)
- M3: Auswertemittel (einschl. FFT-Analyser)

- R: Messwiderstand
- I: Messgröße bzw. Messignal (hier dielektrischer Verschiebestrom)
- U_{R}: Spannungsabfall (Messspannung)
- FFT: Spektrum des Messsignales I

## Patentansprüche

1. Verfahren (100) zur Überwachung von Plasma-Entladungen während eines Oberflächen-Behandlungsverfahrens, bei dem Elektroden in einem gasförmigen Medium zur Erzeugung von Plasma mit einer Wechselspannung (U_{HV}) beaufschlagt werden, wobei die Erzeugung des Plasmas mittels einer dielektrischen Barriere-Entladung erfolgt, mit folgenden Schritten:
Erfassen eines Messignales (Schritt 110);
Separieren von Signalanteilen des Messsignales (I), die oberhalb einer vorgebbaren Frequenz liegen (Schritt 120);
Auswerten der separierten Signalanteile des Messsignales (I) durch Vergleich mit mindestens einer vorgebbaren Referenz (Schritt 130) **dadurch gekennzeichnet, dass** das Messsignal eine direkte Messgröße (I) für die durch die Wechselspannung (U_{HV})in dem Medium erzeugte elektrische Energie darstellt.

2. Verfahren (100) nach Anspruch 1, **dadurch gekennzeichnet, dass** als Messgröße ein das Medium durchdringender elektrischer Strom, insbesondere ein dielektrischer Verschiebestrom (I), gemessen wird (Schritt 110).

3. Verfahren (100) nach einem der vorhergehenden Ansprüche, **dadurch gekennzeichnet, dass** das Separieren der Signalanteile des Messsignales (I) mittels einer Filterung und/oder einer Spektralanalyse, insbesondere einer Fast-Fourier-Analyse (FFT), durchgeführt wird (Schritt 120).

4. Verfahren (100) nach einem der vorhergehenden Ansprüche, **dadurch gekennzeichnet, dass** zum Separieren der Signalanteile des Messsignales (I) eine oberhalb einer anregenden Frequenz liegenden Frequenz vorgegeben wird (Schritt 120).

5. Verfahren (100) nach einem der vorhergehenden Ansprüche, **dadurch gekennzeichnet, dass** das Auswerten der separierten Signalanteile des Messsignales (I) mittels einer Spektralanalyse, insbesondere einer Fast-Fourier-Analyse (FFT), durchgeführt wird, wobei die den Signalanteilen entsprechenden Spektralanteile mit einem als Referenz dienenden Referenzspektrum verglichen werden (Schritt 130).

6. Verfahren (100) nach Anspruch 5, **dadurch gekennzeichnet, dass** das Referenzspektrum vor dem Auftreten einer Plasma-Entladung aufgenommen wird.

7. Verfahren (100) nach einem der Ansprüche 1 bis 4, **dadurch gekennzeichnet, dass** das Auswerten der separierten Signalanteile des Messsignales (I) mittels einer Differenzbildung durchgeführt wird, bei der die Signalanteile des Messsignales (I) mit einem Referenzsignal verglichen werden.

8. Verfahren (100) nach Anspruch 7, **dadurch gekennzeichnet, dass** das Referenzsignal vor dem Auftreten einer Plasma-Entladung aufgenommen wird.

9. Verfahren (100) nach einem der Ansprüche 5 bis 8, **dadurch gekennzeichnet, dass** das Auswerten der separierten Signalanteile des Messsignales (I) mittels eines Schwellwertes, insbesondere eines Signalwertes im Spektral- oder Zeitbereich, durchgeführt wird (Schritt 130).

10. Vorrichtung (MON) zur Überwachung von Plasma-Entladungen während eines Oberflächen-Behandlungsverfahrens, bei dem Elektroden in einem gasförmigen Medium zur Erzeugung von Plasma mit einer Wechselspannung (U_{HV}) beaufschlagt werden, und die Elektroden zur Erzeugung des Plasmas mittels einer dielektrischen Barriere-Entladung beschaffen sind; umfassend:
Detektormittel (M1) zum Erfassen eines Messsignales; Trennmittel (M2) zum Separieren von Signalanteilen des Messsignales (I), die oberhalb einer vorgebbaren Frequenz liegen; und
Auswertungsmittel (M3) zum Auswerten der separierten Signalanteile des Messsignales (I) durch Vergleich mit mindestens einer vorgebbaren Referenz **dadurch gekennzeichnet, dass** das Messsignal eine direkte Messgröße (I) für die durch die Wechselspannung (U_{HV}) in dem Medium erzeugte elektrische Energie darstellt.

11. Vorrichtung (MON) nach Anspruch 10, **dadurch gekennzeichnet, dass** die Detektormittel (M1) einen Messwiderstand (R) umfassen, an dem ein das Medium durchdringender elektrischer Strom, insbesondere ein dielektrischer Verschiebestrom (I), einen. Spannungsabfall (U_{R}) erzeugt.

12. Vorrichtung (MON) nach Anspruch 10 oder 11, **dadurch gekennzeichnet, dass** die Trennmittel (M2) zum Separieren der oberhalb der vorgebbaren Frequenz liegenden Signalanteile des Messsignales (I) mindestens ein Filter und/oder eine Einrichtung zur Spektralanalyse, insbesondere zur Fast-Fourier-Analyse (FFT), umfassen.

13. Vorrichtung (MON) nach einem der Ansprüche 10 bis 12, **dadurch gekennzeichnet, dass** die Auswertemittel (M3) mindestens eine Einrichtung zur Spektralanalyse, insbesondere Fast-Fourier-Analyse (FFT), umfassen.

14. Vorrichtung (MON) nach einem der Ansprüche 10 bis 13, **dadurch gekennzeichnet, dass** die Auswertemittel (M3) Vergleichsmittel umfassen, die die Signalanteile mit einem als Referenz dienenden Referenzspektrum vergleichen.

15. Vorrichtung (MON) nach einem der Ansprüche 10 bis 13, **dadurch gekennzeichnet, dass** die Auswertemittel (M3) Vergleichsmittel umfassen, die die Signalanteile des Messsignales (I) mit einem Referenzsignal vergleichen.

## Claims

1. A method (100) of monitoring plasma discharges during a surface treatment process, wherein electrodes within a gaseous medium are supplied with an alternating voltage (U_{HV}) for generating a plasma, wherein the generating of the plasma is achieved by dielectric barrier discharge, comprising the following steps:
detecting a measuring signal (step 110);
separating signal components of the measuring signal (I), the signal components being above a preset frequency (step 120);
evaluating the separated signal components of the measuring signal (I) by comparing them with at least one preset reference (step 130),
**characterized in that** the measuring signal represents a measurement value (I) of the electric energy being produced by said alternating voltage (U_{HV}) in said medium.

2. The method (100) of claim 1, **characterized in that** an electric current which penetrates the medium is measured as said measure value, in particularly a dielectric displacement current (I) is measured (step 110) .

3. The method (100) of one of the preceding claims, **characterized in that** the separating of the signal components of the measuring signal (I) is performed by a filtering and/or a spectral analysis, in particularly by a Fast-Fourier-Analysis (FFT) (step 120) .

4. The method (100) of one of the preceding claims, **characterized in that** for separating said signal components of the measuring signal (I) a frequency is preset which lies above a stimulating frequency (step 120) .

5. The method (100) of one of the preceding claims, **characterized in that** the evaluating of the separated signal components of the measuring signal (I) is performed by means of a spectral analysis, in particular by a Fast-Fourier-Analysis (FFT), wherein spectral components, corresponding to the signal components, are compared with a reference spectrum being used as a reference (step 130).

6. The method (100) of claim 5, **characterized in that** the reference spectrum is recorded before the occurrence of a plasma-discharge.

7. The method (100) of one of claims 1 to 4, **characterized in that** evaluating of the separated signal components of the measurement signal (I) is performed by a computation of a difference, **in that** the signal components of the measuring signal (I) is compared with a reference signal.

8. The method (100) of claim 7, **characterized in that** the reference signal is recorded before the occurrence of a plasma discharge.

9. The method (100) of one of claims 5 to 8, **characterized in that** the evaluating of the separated signal components of the measurement signal (I) is performed by means of a threshold, in particular by means of a signal value in the spectral domain or the time domain (step 130).

10. A device (MON)for monitoring plasma discharges during a surface treatment process, wherein electrodes within a gaseous medium are supplied with an alternating voltage (U_{HV}) for generating a plasma, wherein the electrodes within a gaseous medium are supplied with an alternating voltage (U_{HV}) for generating a plasma, and wherein the electrodes are configured for generating the plasma by means of dielectric barrier discharge, the device comprising:
detector means (M1) for detecting a measuring signal;
separating means (M2) for separating signal components of the measuring signal (I), said components being above a preset frequency; and
evaluating means (M3) for evaluating the separated signal components of the measuring signal (I) by comparing them with at least one preset reference, **characterized in that** the measuring signal represents a measurement value (I) for the electric energy being generated by said alternating voltage (U_{HV}).

11. The device (MON) of claim 10, **characterized in that** the detector means (M1) comprises a measurement resistor (R) with a current generating a voltage drop (U_{R}), the current being a current which penetrates said medium, in particular being a dielectric displacement current (I).

12. The device (MON) of claim 10 or 11, **characterized in that** the separating means (M2) for separating the signal components of the measuring signal (I) being above said preset frequency at least comprises a filter and/or a device for spectral analysis, in particularly for Fast-Fourier-Analysis (FFT).

13. The device (MON) of one of claims 10 to 12, **characterized in that** the evaluating means (M3) at least comprises a device for spectral analysis, in particularly for Fast-Fourier-Analysis (FFT).

14. The device (MON) of one of claims 10 to 13, **characterized in that** the evaluating means (M3) comprises comparator means which compare the signal components with a reference spectrum being used as reference.

15. The device (MON) of claim 10 to 13, **characterized in that** the evaluating means (M3) comprises comparator means which compare the signal components of the measuring signal (I) with a reference signal.

## Revendications

1. Un procédé (100) de surveillance des décharges plasma pendant un traitement de surface, dans lequel on fournit, pour générer un plasma, des électrodes dans un milieu gazeux soumises à une tension alternative (U_{HV}), dans lequel la génération du plasma est obtenue par une décharge de barrière diélectrique, comprenant les étapes suivantes :
la détection d'un signal de mesure (étape 110) ;
la séparation des composantes de signal du signal de mesure (I), les composantes du signal étant au-dessus d'une fréquence prédéfinie (étape 120) ;
l'évaluation des composantes séparées du signal de mesure (I) par leur comparaison avec au moins une référence prédéfinie (étape 130) ;
**caractérisé en ce que** le signai de mesure représente une valeur de mesure (I) de l'énergie électrique produite par ladite tension alternative (U_{HV}) au sein du milieu.

2. Le procédé (100) de la revendication 1, **caractérisé en ce que** l'on mesure un courant électrique pénétrant le milieu en tant que valeur de mesure, en particulier un courant de déplacement diélectrique (I) est mesuré (étape 110).

3. Le procédé (100) de l'une quelconque des revendications précédentes, **caractérisé en ce que** la séparation des composantes de signal du signal de mesure (I) est réalisée au moyen d'une analyse filtrante et / ou spectrale, notamment une analyse de Fourier rapide (FFT) (étape 120).

4. Le procédé (100) de l'une des revendications précédentes, **caractérisé en ce que** pour séparer lesdites composantes de signal du signal de mesure (I), une fréquence située au-dessus d'une fréquence de stimulation est prédéterminée (étape 120).

5. Le procédé (100) de l'une des revendications précédentes, **caractérisé en ce que** l'on effectue l'analyse des composantes de signal séparées du signal de mesure (I) au moyen d'une analyse spectrale, en particulier une analyse de Fourier rapide (FFT), dans laquelle les composantes spectrales, correspondant aux composantes de signal, sont comparées avec un spectre de référence utilisé en qualité de référence (étape 130).

6. Le procédé (100) de la revendication 5, **caractérisé en ce que** le spectre de référence est enregistré avant l'apparition d'une décharge de plasma.

7. Le procédé (100) de l'une des revendications 1 à 4, **caractérisé en ce que** l'évaluation des composantes de signal séparées du signal de mesure (I) est réalisée par un calcul de différence dans laquelle les composantes de signal du signal de mesure (I) sont comparées à un signal de référence.

8. Le procédé (100) de la revendication 7, **caractérisé en ce que** le signal de référence est enregistré avant l'apparition d'une décharge de plasma.

9. Le procédé (100) de l'une quelconque des revendications 5 à 8, **caractérisé en ce que** l'évaluation des composantes de signal séparées du signal de mesure (I) est réalisée au moyen d'une valeur de seuil, notamment une valeur de signal dans le domaine spectral ou dans le domaine temporel (étape 130).

10. Un dispositif (MON) pour la surveillance des décharges plasma pendant un traitement de surface, dans lequel, pour produire du plasma, on fournit des électrodes soumises à une tension alternative (U_{HV}) dans un milieu gazeux, dans lequel les électrodes au sein du milieu gazeux sont fournies avec une tension alternative (U_{HV}) pour générer un plasma, et dans lequel les électrodes sont configurées pour générer le plasma au moyen d'une décharge de barrière diélectrique, le dispositif comprenant :
des moyens de détection (M1) pour détecter un signal de mesure ;
des moyens de séparation (M2) pour séparer les composantes de signal du signal de mesure (I), lesdites composantes se situant au-dessus d'une fréquence prédéterminée ; et
des moyens d'évaluation (M3) pour évaluer les composantes de signal séparées du signal de mesure (I) par comparaison avec au moins une référence prédéterminée,
**caractérisé en ce que** le signal de mesure représente une valeur de mesure (I) pour l'énergie électrique qui est générée par ladite tension alternative (U_{HV}).

11. Le dispositif (MON) de la revendication 10, **caractérisé en ce que** les moyens de détection (M1) comprennent une résistance de mesure (R) avec un courant générant une chute de tension (U_{R}), le courant étant un courant pénétrant ledit milieu, en particulier un courant de déplacement diélectrique (I).

12. Le dispositif (MON) de la revendication 10 ou 11, **caractérisé en ce que** les moyens de séparation (M2) pour la séparation des composantes de signal du signal de mesure (I) qui sont au-dessus de ladite fréquence prédéterminée comportent au moins un filtre et/ou un dispositif d'analyse spectrale, en particulier pour une analyse de Fourier rapide (FFT).

13. Le dispositif (MON) de l'une des revendications 10 à 12, **caractérisé en ce que** les moyens d'évaluation (M3) comprennent au moins un dispositif d'analyse spectrale, notamment d'analyse de Fourier rapide (FFT).

14. Le dispositif (MON) de l'une des revendications 10 à 13, **caractérisé en ce que** les moyens d'évaluation (M3) comprennent des moyens de comparaison qui comparent les composantes de signal avec un spectre de référence servant de référence.

15. Le dispositif (MON) de l'une des revendications 10 à 13, **caractérisé en ce que** les moyens d'évaluation (M3) comprennent des moyens de comparaison qui comparent les composantes de signal du signal de mesure (I) avec un signal de référence.
